Europäisches Patentamt

European Patent Office

Office européen des brevets

(11) Publication number : **0 541 405 A1**

(12) # EUROPEAN PATENT APPLICATION

(21) Application number : **92310245.3**

(22) Date of filing : **09.11.92**

(51) Int. Cl.⁵ : **H01L 23/485**

(30) Priority : **07.11.91 KR 9119752**

(43) Date of publication of application :
**12.05.93 Bulletin 93/19**

(84) Designated Contracting States :
**DE FR GB IT**

(71) Applicant : **SAMSUNG ELECTRONICS CO. LTD.**
**416 Maetan-dong, Kwonson-gu**
**Suwon-city, Kyounggi-do (KR)**

(72) Inventor : **Ha, Jung-min**
**15-205 Eunma Apt., 316 Daechi-dong**
**Kangnam-ku, Seoul (KR)**
Inventor : **Shin, Hong-jae**
**189-3 Cheolsan 5-dong**
**Kwangmyeong-city, Kyungki-di (KR)**
Inventor : **Kim, Young-wug**
**102-307, Hanshin Apt., 310-6 Ingye-dong**
**Kwonsun-ku, Suwon (KR)**

(74) Representative : **Stanley, David William et al**
**APPLEYARD LEES 15 Clare Road**
**Halifax West Yorkshire HX1 2HY (GB)**

(54) **Bond pad for semiconductor device.**

(57)   A semiconductor device includes a bonding pad which electrically connects a metal wiring of a semiconductor device to a package lead ; and a passivation layer covering the bonding pad and the metal wiring. The bonding pad or the metal wiring has an obtuse-angled or rounded corner C1, C2. Due to this, generation of a crack in the passivation layer is markedly suppressed, thereby enhancing the reliability of the semiconductor device.

FIG. 2A

FIG. 2B

EP 0 541 405 A1

The present invention relates to semiconductor devices, and more particularly to semiconductor devices having a bonding pad and metal wiring.

Generally speaking, following patterning of a final metal layer of a semiconductor device, a passivation layer is deposited over the entire top surface of the wafer. This is an insulating, protective layer that prevents mechanical and chemical damage during subsequent assembly and packaging. Widely used passivation layers include a phosphosilicate glass (PSG) layer having good gettering properties with respect to sodium ions and other fast-diffusing metallic contaminants and a PECVD silicon nitride film which exhibits good mechanical properties. After formation, openings are etched into this passivation layer to expose a set of special metallization patterns formed beneath the passivation layer. These metal patterns are normally located in the periphery of the circuit and called bonding pads. These bonding pads are typically about 100 X 100$\mu$m in size and separated by 50-100$\mu$m spaces. Wires are connected or bonded to the metal surface of the bonding pads and then bonded into the chip package. In this way, connections are established between the chip and the package leads.

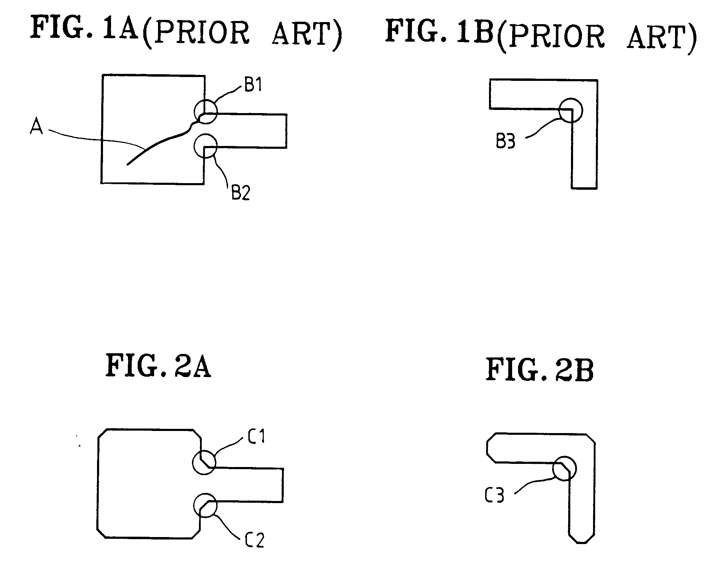

In a conventional semiconductor device, a metal pattern is formed such that the metal wirings are rectangular and the bonding pads are square. Figures 1A and 1B of the accompanying diagrammatic drawings show a pattern of conventional bonding pads which are electrically connected to a circuit via a metal wiring and a pattern of metal wiring. Here, the conventional bonding pad and metal wiring have square corners B1, B2 and B3. As mentioned above, after forming the bonding pads and metal wirings of a semiconductor device, a passivation layer is coated thereon. Then, a subsequent heat-treating step follows. In such a case, a high probability exists that a crack A, as shown in Figure 1A, is generated in the passivation layer covering the bonding pads or the metal wirings, to thereby reduce reliability of the semiconductor device. According to experiments of the present inventors, crack generation in the passivation layer has turned out to be closely related to the differences of the physical properties between the passivation layer and the metal bonding pads and/or the metal wiring which underlie the passivation layer.

Preferred embodiments of the present invention aim to provide a bonding pad or a metal wiring which prevents crack generation in a passivation layer covering the bonding pad and/or the metal wiring of a semiconductor device during a subsequent heat-treatment step.

To accomplish this aim, preferred semiconductor device of the present invention is characterized in that a bonding pad and/or a portion of a metal wiring of the semiconductor device is/are shaped so as to form a rounded or an obtuse-angled corner.

Briefly, according to one aspect of the present invention, there is provided a semiconductor device comprising a bonding pad for electrically connecting a metal wiring of a semiconductor device to a package lead of the semiconductor device, and a passivation layer covering the bonding pad and the metal wiring, wherein the metal wiring forms an obtuse-angled or rounded corner at the junction between the metal wiring and the bonding pad to thereby suppress crack generation in the passivation layer in a subsequent heat-treatment step.

As a material for use as the metal wiring or the bonding pad, Al, Mo, W, Au , Cu alloys thereof, etc. may be mentioned. As a passivation layer, a silicon oxide layer, a PSG layer, a silicon oxide layer doped with boron and/or phosphorus atoms, a silicon nitride layer, etc., may be mentioned. These layers can be used alone or combined as a composite layer of two or more layers. By forming a composite layer as the passivation layer, the percentage of crack generation can be further reduced over the use of a single layer.

By forming the bonding pad and/or the metal wiring having rounded or obtuse-angled corners, a reduction in crack generation percentage in the passivation layer formed thereon, has been verifiably established. This seems to be due to the fact that stress between the bonding pad and/or the metal wiring and a passivation layer is distributed. Similarly, for reducing the probability of the crack generation as above, a metal wiring pattern may be formed to form an obtuse-angled or rounded shape at a protruding portion thereof, thereby suppressing the stress concentration in an upper layer formed thereon.

In another aspect, the invention provides a semiconductor device comprising a bonding pad having a rounded or an obtuse-angled corner at a junction with an inner metal wiring.

A semiconductor device as above may further comprise a metal wiring having an obtuse-angled or rounded corner at the junction between said metal wiring and said bonding pad.

According to a further aspect of the present invention, there is provided a semiconductor device comprising a metal wiring having a rounded or an obtuse-angled corner.

A semiconductor device as above may further comprise a bonding pad for electrically connecting said metal wiring to a package lead of said semiconductor device.

Preferably, said metal wiring forms an obtuse-angled or rounded corner at the junction between said metal wiring and said bonding pad.

According to another aspect of the present invention, there is provided a semiconductor device comprising a metal layer which is patterned in an obtuse-angled or rounded protruding shape.

According to a further aspect of the present invention, there is provided a semiconductor device comprising a metal layer having an obtuse-angled or rounded corner and a composite layer formed thereon consisting of a PSG layer and a silicon nitride layer.

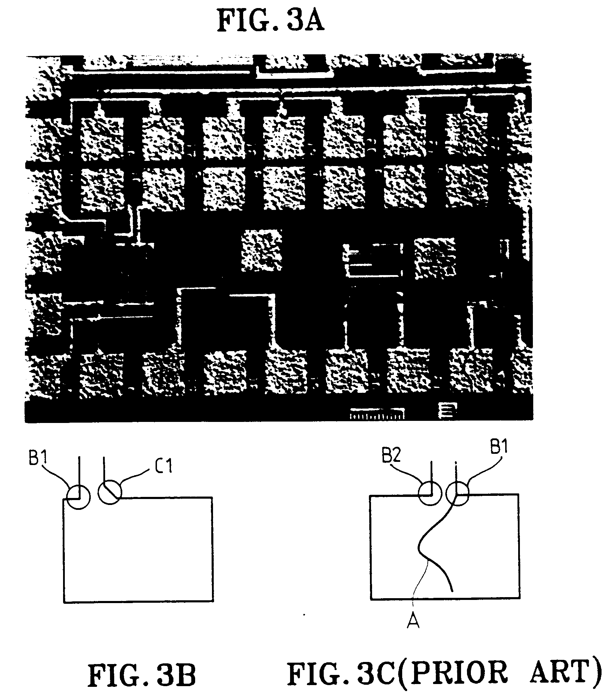

For a better understanding of the invention, and to show how the same may be carried into effect, reference will now be made, by way of example, to Figures 2 and 3 of the accompanying diagrammatic drawings, in which:

Figures 2A and 2B show one example of the pattern of a bonding pad according to the present invention, which is electrically connected to a semiconductor circuit via a metal wiring, and the pattern of the metal wiring, respectively;

Figure 3A is an SEM picture which shows a top view of a semiconductor wafer having both a prior art bonding pad which is electrically connected to a semiconductor circuit via a metal wiring, and one embodying to the present invention;

Figure 3B shows the pattern of a bonding pad in Figure 3A (bottom row fifth from left), which is an embodiment of the present invention; and

Figure 3C shows the pattern of a prior art bonding pad in Figure 3A (bottom row eighth from left) and a crack formed in a transparent passivation layer after a heat-treatment step.

Figures 2A and 2B show respectively the pattern of a bonding pad according to one embodiment of the present invention electrically connected to a semiconductor circuit via a metal wiring, and a pattern of a metal wiring according to one embodiment of the present invention. Here, the patterns of the bonding pad and the metal wiring have obtuse-angled corners C1, C2 and C3. Instead of the illustrated obtuse-angled corners, a bonding pad or a metal wiring having a rounded corner (not shown in the drawings) can suppress crack generation in a passivation layer, as well. Forming a pad or a metal wiring whose shape consists of an obtuse angle or a rounded corner distributes a stress between the bonding pad and/or the metal wiring and the passivation layer, thereby suppressing the generation of a crack in the passivation layer.

After forming 100 x 100μm bonding pads as shown in Figure 1A (prior art) and as shown in Figure 2A (an embodiment of the present invention) on one semiconductor wafer, a passivation layer was formed over the entire surface of the semiconductor wafer. Here, the metal wiring which is electrically connected to the bonding pad has a line width of 20μm. As the metallization layer for forming the bonding pads and metal wirings, an Al-Si alloy layer was deposited. As passivation layers, PSG layers having thicknesses of 3,000Å, 5,000Å and 8,000Å, a composite layer consisting of silicon nitride layer (thickness: 3,000Å) and a PSG layer (thickness: 3,000Å, 5,000Å and 8,000Å) and another composite layer consisting of silicon nitride layer (thickness: 6,000Å) and a PSG layer (thickness: 5,000Å and 8,000Å) were used in respective test cases. In every case, the PSG layer is closely adhered to the metal layer. After performing four 30-minute annealing operations at a temperature of 450°C to these samples without openings, the crack generation percentage was estimated for the passivation layer over the bonding pads. The results are shown in Table 1 below.

As can be seen from Table 1, the crack generation percentage in the passivation layer has been remarkably reduced by forming the bonding pads with obtuse-angled corners and forming the metal wiring so as to create an obtuse angle at the junction between the metal wiring and the bonding pad. Also, we can see that when the composite layer consisting of a PSG layer and silicon nitride layer was used as the passivation layer, the crack generation percentage is less than when using a single PSG layer.

## Table 1

| Passivation Layer | Thickness (Å) | Prior Art (Fig. 1A) | Present Invention (Fig. 2A) |
|---|---|---|---|
| PSG | 3,000 | 60% | 0% |
| PSG | 5,000 | 75% | 0% |
| PSG | 8,000 | 100% | 50% |
| silicon nitride + PSG | 3,000 + 3,000 | 5% | 0% |
| silicon nitride + PSG | 3,000 + 5,000 | 10% | 0% |
| silicon nitride + PSG | 3,000 + 8,000 | 15% | 0% |
| silicon nitride + PSG | 6,000 + 5,000 | 0% | 0% |
| silicon nitride + PSG | 6,000 + 8,000 | 5% | 0% |

Note: all bonding pad dimensions are 100 x 100$\mu$m

Figure 3A is an SEM picture which shows a top view of a semiconductor wafer having both a prior art bonding pad which is electrically connected to a semiconductor circuit via a metal wiring, and one according to one embodiment of the present invention. The structure of Figure 3 was obtained according to the following procedure.

After forming semiconductor devices on a semiconductor wafer, contact holes are opened to electrically connect the active regions to a metallization layer which is formed in a subsequent process. Thereafter, the metallization layer is deposited and patterned to form metal wirings and bonding pads over the whole surface of the semiconductor wafer. Here, the patterning is performed so that both conventional, square bonding pads and rectangular metal wirings and those forming an obtuse-angled corner in accordance with the present invention, are formed on the same chip. Next, as the metallization layer, Al or Al alloy is generally deposited, but may be substituted with Mo, W, Au, Cu, etc., or alloys thereof. Then, a passivation layer is formed on the resultant by depositing a PSG layer to a thickness of 8,000Å. In place of the PSG layer, a silicon oxide layer, a silicon oxide layer doped with boron and/or phosphorus, a silicon nitride layer, etc., can be used alone or in combination. After thrice performing a 30-minute annealing operation at a temperature of 450°C, the SEM picture of Figure 3A was taken.

Two pads of the above structure are selectively shown. That is, Figure 3B shows the pattern of a bonding pad (bottom row, fifth from left) which is an embodiment of the present invention and Figure 3C shows the pattern of a prior art bonding pad (bottom row, eighth from left), which exhibits a crack generated after the heat-treatment step. As can be seen from Figures 3A and 3C, when the junction between the metal wiring and the bonding pad forms a square corner, a crack A is generated in the passivation layer. On the other hand, when the metal wiring is provided with an obtuse-angled corner where it meets the bonding pad, the crack is absent as shown in Figures 3A and 3B. In the meantime, concerning the square corner B1 in Figure 3B, cracks are absent here, too. This seems to be due to the fact that the surface area to the lower-left of point B1 is small.

According to an actually calculated estimate by the present inventors, the crack generation frequency in the above experiment was 94% in the case of the prior art and 22 % for the embodiment of the present invention. Here, the crack generation percentage is calculated as the number of bonding pads covered by a passivation layer having a crack formed thereon divided by the number of all bonding pads thus obtained.

According to the illustrated embodiments of the present invention, the semiconductor device includes a bonding pad and/or a metal wiring having an obtuse-angled or rounded corner. Such a portion distributes the stress between the bonding pad and/or metal wiring and a passivation layer covering these. Therefore, crack generation in the passivation layer covering the bonding pad and/or the metal wiring can be easily suppressed, thereby enhancing the reliability of a semiconductor device.

While preferred embodiments of the present invention have been particularly shown and described, it will be understood by those skilled in the art that various changes in form and detail may be made therein without departing from the spirit and the scope of the present invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A semiconductor device comprising:
   a bonding pad for electrically connecting a metal wiring of said semiconductor device to a package lead of said semiconductor device; and
   a passivation layer covering said bonding pad and said metal wiring:
   wherein said metal wiring forms an obtuse-angled or rounded corner at the junction between said metal wiring and said bonding pad, thereby suppressing crack generation in said passivation layer in a heat-treatment step thereof.

2. A semiconductor device as claimed in claim 1, wherein said metal wiring or said bonding pad comprises any one selected from a group consisting of Al, Mo, W, Au, Cu and alloys thereof.

3. A semiconductor device as claimed in claim 1 or 2, wherein said passivation layer is a single layer or a composite layer consisting of two or more layers selected from a group consisting of a silicon oxide layer, a PSG layer, a silicon oxide layer doped with boron or phosphorus atoms, and a silicon nitride layer.

4. A semiconductor device comprising a bonding pad having a rounded or an obtuse-angled corner at a junction with an inner metal wiring.

5. A semiconductor device as claimed in claim 4, further comprising a metal wiring having an obtuse-angled or rounded corner at the junction between said metal wiring and said bonding pad.

6. A semiconductor device comprising a metal wiring having a rounded or an obtuse-angled corner.

7. A semiconductor device as claimed in claim 6, further comprising a bonding pad for electrically connecting said metal wiring to a package lead of said semiconductor device.

8. A semiconductor device as claimed in claim 7, wherein said metal wiring forms an obtuse-angled or rounded corner at the junction between said metal wiring and said bonding pad.

9. A semiconductor device comprising a metal layer which is patterned in an obtuse-angled or rounded protruding shape.

10. A semiconductor device comprising a metal layer having an obtuse--angled or rounded corner, and a composite layer formed thereon consisting of a PSG layer and a silicon nitride layer.

EP 0 541 405 A1

# FIG. 1A(PRIOR ART)　FIG. 1B(PRIOR ART)

B1

A

B2

B3

# FIG. 2A　　　　　FIG. 2B

C1

C2

C3

7

# FIG. 3A

FIG. 3B

FIG. 3C(PRIOR ART)

European Patent Office

**EUROPEAN SEARCH REPORT**

Application Number

EP    92 31 0245

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 10, no. 104 (E-397)19 April 1986 & JP-A-60 242 643 ( HITACHI SEISAKUSHO ) 2 December  1985 | 1,4-9 | H01L23/485 |
| Y | * abstract * | 10 | |
| X | PATENT ABSTRACTS OF JAPAN vol. 14, no. 178 (E-915)10 April 1990 & JP-A-20 30 154 ( SEIKO EPSON ) 31 January  1990 * abstract * | 1,2,4 | |
| X | PATENT ABSTRACTS OF JAPAN vol. 10, no. 65 (E-388)14 March 1986 & JP-A-60 217 652 ( HITACHI SEISAKUSHO ) 31 October 1985 * abstract * | 1,4,9 | |
| Y | PATENT ABSTRACTS OF JAPAN vol. 12, no. 320 (E-651)30 August 1988 & JP-A-63 084 122 ( MATSUSHITA ELECTRONICS CORP ) 14 April 1988 * abstract * | 10 | TECHNICAL FIELDS SEARCHED (Int. Cl.5) H01L |
| A | EP-A-0 414 412 (HITACHI LTD) * abstract; figure 3A * | 1,4 | |

The present search report has been drawn up for all claims

| Place of search | Date of completion of the search | Examiner |
|---|---|---|
| THE HAGUE | 20 JANUARY 1993 | GREENE S.K. |